# EUROPÄISCHE PATENTSCHRIFT

(11) **EP 4 286 749 B1**
(45) Veröffentlichungstag und Bekanntmachung des Hinweises auf die Patenterteilung: **14.08.2024**
(21) Anmeldenummer: 23172272.9
(22) Anmeldetag: 09.05.2023
(51) Int. Cl.: F24C 15/16, A47B 88/43

(54) **SCHNELLBEFESTIGUNGSSYSTEM FÜR EINEN TELESKOPAUSZUG**
QUICK-FIT SYSTEM FOR TELESCOPIC SLIDE
SYSTÈME DE FIXATION RAPIDE POUR UNE GLISSIÈRE TÉLESCOPIQUE

(30) Priorität: 31.05.2022 DE 102022113764
(43) Veröffentlichungstag der Anmeldung: 06.12.2023
(73) Patentinhaber: Accuride International GmbH, 65582 Diez/Lahn (DE)
(72) Erfinder: Heffel, Andreas, 56269 Dierdorf (DE); Diefenbach, Karsten, 56368 Katzenelnbogen (DE)
(74) Vertreter: WSL Patentanwälte Partnerschaft mbB

(56) Entgegenhaltungen:
- WO-A1-2010/100198
- WO-A1-2011/023561
- DE-A1- 102018 116 219
- US-A1- 2018 084 910

## Beschreibung

### GEGENSTAND DER ERFINDUNG

Die vorliegende Erfindung betrifft ein Schnellbefestigungssystem, welches geeignet und ausgelegt ist für ein lösbares Montieren eines Teleskopauszugs, welcher ein stationäres Schienenelement und wenigstens ein gegenüber dem stationären Schienenelement verfahrbar gelagertes Schienenelement aufweist, in einer im Wesentlichen horizontalen Ausrichtung des Teleskopauszugs an einem Korpus, vorzugsweise am Korpus von Möbeln, einschließlich Backöfen, Technikschränken und Computerracks.

### HINTERGRUND DER ERFINDUNG

Teleskopauszüge für beispielsweise Möbel weisen ein stationäres Schienenelement auf, das am Möbelkorpus festgelegt wird, und wenigstens ein gegenüber dem stationären Schienenelement über Gleitlager, Kugellager oder Walzenlager verfahrbar gelagertes Schienenelement zum Ausziehen und Einschieben eines daran befestigten oder darauf aufgelegten Auszugs, wie einer Schublade, eines Tablars oder eines Gargutträgers. Insbesondere bei Backöfen, Technikschränken und Computerracks, aber auch anderen Anwendungen, kann es erforderlich oder zumindest vorteilhaft sein, wenn die Teleskopauszüge ohne Werkzeug leicht montiert und demontiert werden können, um sie auszutauschen, zu reinigen oder einfach in einer gerade benötigten Höhe im Möbelkorpus anzuordnen. Zu diesem Zweck sind unterschiedliche Schnellbefestigungssysteme für Teleskopauszüge bereits bekannt.

Bei vielen handelsüblichen Backöfen, bei welchen die vorliegende Erfindung besonders bevorzugt und mit Vorteil einsetzbar ist, werden zwei einander gegenüberliegende Seitengitter (Montagegitter) an den Innenwänden der Backofenmuffel befestigt, die zum Einschieben oder Auflegen von Gargutträgern (Backblechen, Backrosten, Tropfschalen etc.) oder auch zur Befestigung von Teleskopauszügen dienen.

Üblicherweise weisen solche Seitengitter in der an einer Muffelinnenwand montierten Ausrichtung wenigstens zwei vertikal und im Wesentlichen parallel zueinander angeordnete Gitterstäbe auf sowie üblicherweise eine Mehrzahl von horizontalen Gitterstäben, welche an den vertikalen Gitterstäben befestigt sind und diese verbinden. Die horizontalen Gitterstäbe der auf beiden Seiten an den Muffelinnenwänden angeordneten Seitengitter dienen zum Auflegen und Einschieben der Gargutträger, weshalb sie üblicherweise in einem Abstand vor der von den vertikalen Gitterstäben gebildeten Ebene in Richtung des Muffelinneren angeordnet sind. Zur Verbindung mit und zur Befestigung an den vertikalen Gitterstäben weisen die horizontalen Gitterstäbe an ihren gegenüberliegenden Enden jeweils einen abgewinkelten Endabschnitt auf.

Damit der Gargutträger nicht abkippt, wenn er zum Beispiel zum Bearbeiten oder Begutachten des Garguts nicht vollständig aus der Muffel des Backofens herausgezogen wird, sind bei derartigen Seitengittern regelmäßig Paare von horizontalen Gitterstäben vorgesehen, die in einem geringen Abstand übereinander angeordnet sind, welcher ausreichend groß ist, um den Gargurtträger zwischen die beiden horizontalen Gitterstäbe einzuschieben, der aber ausreichend gering ist, dass sich der Gargutträger mit einer hinteren Kante gegen ein Abkippen am oberen horizontalen Gitterstab abstützen kann. Üblicherweise bestehen die horizontalen Gitterstäbe aus einem Draht mit kreisförmigem Querschnitt, weil dies eine kostengünstige Herstellung erlaubt.

Moderne und höherwertige Backöfen werden mit Teleskopauszügen zum Halten und Verfahren der Gargurtträger ausgerüstet. Neben der leichtgängigen Verfahrbarkeit der Gargutträger ist ein weiterer Vorteil der Verwendung von Teleskopauszügen, dass diese bei ausreichender Anzahl verfahrbarer Schienenelemente auch ein vollständiges Herausziehen des Gargutträgers aus der Muffel erlauben, ohne dass der Gargutträger abkippt. Zweckmäßigerweise werden solche Teleskopauszüge an den vorhandenen Seitengittern befestigt, wobei eine stabile, aber einfach lösbare und wieder montierbare Befestigung zweckmäßig ist, um die Teleskopauszüge zum Reinigen oder zum Wechseln der Positionshöhe innerhalb der Muffel leicht herausnehmen und wieder einsetzen zu können.

Zu diesem Zweck sind verschiedenste Systeme zur lösbaren Befestigung von Teleskopauszügen an Seitengittern bekannt, bei denen wenigstens ein, häufig zwei oder auch mehr Befestigungselemente zum Verbinden des Teleskopauszugs an den Stäben des Seitengitters vorgesehen sind.

Die EP 2 403 380 beschreibt eine Schnellbefestigungseinrichtung für Teleskopauszüge an einem Seitengitter beispielsweise eines Backofens mit zwei sogenannten Klammern, die in der Nähe der beiden Endabschnitte an der Unterseite des stationären Schienenelements befestigt sind und mit denen der Teleskopauszug auf der Oberseite und nicht auf der zum Muffelinnenraum weisenden Seite eines horizontalen Gitterstabs des Seitengitters montiert wird, damit der Teleskopauszug möglichst nahe an der Muffelseitenwand platziert wird und nur gering in den Muffelinnenraum hineinragt. Die beiden Klammern weisen jeweils U-förmige Abschnitte auf, die zur Montage des Teleskopauszugs waagerecht in Richtung der Muffelseitenwand auf den horizontalen Gitterstab aufgeschoben werden und diesen klammerartig umgreifen. Des Weiteren sind an den Klammern Abschnitte vorgesehen, die sich an den vertikalen Stäben des Seitengitters abstützen oder diese ebenfalls klammerartig umgreifen. Die Klammern sollen den Teleskopauszug gegen ein Verschieben und Verkippen an den Gitterstäben des Seitengitters in mehrere Raumrichtungen abstützen. In einer Variante der Klammern, welche für die Montage des Teleskopauszugs im vorderen, der Muffelöffnung zugewandten Abschnitt vorgesehen sind, ist eine federnd befestigte Rast vorgesehen, mit welcher die Klammer an dem abgebogenen Endabschnitt oder an dem nach hinten in Richtung Muffelrückwand verlaufenden Abschnitt des horizontalen Gitterstabs verrastet wird. Dabei hintergreift die Rast den horizontalen Gitterstab auf einer durch einen Benutzer schlecht zugänglichen Seite, was ein Au-ßereingriffbringen der Rast für eine Demontage erschweren würde, wenn die Rast in dem an dem horizontalen Gitterstab anliegenden Bereich nicht mit einer Schräge versehen wäre, die offensichtlich ein leichteres Abziehen der Klammer von dem Gitterstab gewährleisten soll. Dadurch kann sich der Teleskopauszug aber auch unbeabsichtigt leichter von dem Seitengitter lösen.

Die EP 1 965 680 beschreibt ein Schnellbefestigungssystem zur Befestigung eines Teleskopauszugs an einem Seitengitter beispielsweise eines Backofens mit zwei Schnellbefestigungselementen, die in der Nähe der beiden Endabschnitte an der der Muffelseitenwand zugewandten Seite des stationären Schienenelements befestigt sind und mit denen der Teleskopauszug auf der zum Muffelinnenraum weisenden Seite eines horizontalen Gitterstabs des Seitengitters montiert wird. Jedes der zwei Schnellbefestigungselemente weist zwei U-förmige Abschnitte auf, die im Wesentlichen in einem Winkel von 90° zueinander ausgerichtet sind. Ein erster U-förmiger Abschnitt jedes der zwei Schnellbefestigungselemente umgreift klammerartig den horizontalen Gitterstab in seinem Längserstreckungsbereich, wobei die Öffnung des U-förmiger Abschnitts in Richtung der Muffelseitenwand weist. Der senkrecht zum ersten U-förmigen Abschnitt angeordnete zweite U-förmiger Abschnitt jedes der zwei Schnellbefestigungselemente umgreift den horizontalen Gitterstab an jeweils einem der abgewinkelten Endabschnitte, wobei die Öffnungen dieser zweiten U-förmigen Abschnitte aufeinander zu weisen. Wie bei der zuvor beschriebenen Schnellbefestigungseinrichtung wird der Teleskopauszug mit den beiden Schnellbefestigungselementen zur Montage des Teleskopauszugs waagerecht in Richtung der Muffelseitenwand auf den horizontalen Gitterstab aufgeschoben. Die den Gitterstab an den abgewinkelten Endabschnitten umgreifenden zweiten U-förmigen Abschnitte verhindern ein Abkippen des Teleskopauszugs. An den ersten U-förmigen Abschnitten für den Eingriff mit dem horizontalen Gitterstab in seinem Längserstreckungsbereich ist eine eingeprägte Rast zur Sicherung des Befestigungselements am Gitterstab vorgesehen, weshalb beim Aufschieben der Schnellbefestigungselemente eine Kraft aufgebracht werden muss, um die U-förmigen Abschnitte mit dem Gitterstab zu verrasten. Für die Montage des hinteren Schnellbefestigungselements in der Nähe der Muffelrückwand erfordert dies, dass eine Bedienperson weit in die Backofenmuffel hineingreifen muss, um das hintere Ende des Teleskopauszugs mit dem hinteren Schnellbefestigungselement genau an dem abgewinkelten Endabschnitt des horizontalen Gitterstabs zu positionieren und die für das Einrasten erforderliche Kraft aufzubringen.

In den folgenden Dokumenten werden auch relevante Befestigungssysteme für Teleskopschienen aus dem Stand der Technik vorgestellt: DE 102018116219 A1, US 2018/084910 A1 und WO 2011/023561 A1.

### AUFGABE DER ERFINDUNG

Die Aufgabe der vorliegenden Erfindung bestand darin, ein Schnellbefestigungssystem für ein lösbares Montieren eines Teleskopauszugs an einem Korpus bereitzustellen, das die Nachteile bekannter Schnellbefestigungssysteme überwindet, eine einfache Montage und Demontage des Teleskopauszugs an einem Seitengitter erlaubt und einen einfachen und kostengünstig herzustellenden Aufbau besitzt.

### BESCHREIBUNG DER ERFINDUNG

Gelöst wird diese Aufgabe durch ein Schnellbefestigungssystem der eingangs genannten Art, wie es in den anhängenden Patentansprüchen definiert ist und welches geeignet und ausgelegt ist für ein lösbares Montieren eines Teleskopauszugs, welcher ein stationäres Schienenelement und wenigstens ein gegenüber dem stationären Schienenelement verfahrbar gelagertes Schienenelement aufweist, in einer im Wesentlichen horizontalen Ausrichtung des Teleskopauszugs an einem Korpus.

### Definitionen

Der Begriff Korpus umfasst erfindungsgemäß jede Fläche, an der ein Teleskopauszug zweckmäßigerweise in einer im Wesentlichen horizontalen Ausrichtung festgelegt wird, um einen Auszug gegenüber dem Korpus zu verfahren, insbesondere Möbel, wie Schränke, Backöfen, Kühl- und Tiefkühlschränke, Technikschränke und Computerracks, in denen Auszüge, wie Schubladen, Tablare, Gargutträger etc. gegenüber einer Wandfläche bzw. Innenwandfläche ausziehbar gelagert werden. Besonders vorteilhaft ist die vorliegende Erfindung in Backöfen einsetzbar, in denen Gargutträger in der Backofenmuffel über Paare von an den Muffelseitenwänden gegenüberliegend festgelegten Teleskopauszügen ausziehbar gelagert werden.

Wenn hierin und im Zusammenhang mit der vorliegenden Erfindung und ihrer Definition von "horizontal", "horizontaler Ausrichtung", "vertikal", "vertikaler Ausrichtung", "oben", "unten", "seitlich", "vorne" und "hinten" die Rede ist, so dient dies dazu, die bestimmungsgemäße Orientierung und Ausrichtung der Erfindung, einzelner Elemente der Erfindung oder anderer Elemente, die im Zusammenhang mit der Erfindung stehen, im dreidimensionalen Raum zu beschreiben und die Orientierung und Anordnung von Elementen zueinander und deren Merkmale und Ausgestaltungen zu definieren. Es versteht sich, dass solche Orientierungs- und Anordnungsangaben, auch wenn sie die bestimmungsgemäße und/oder bevorzugte Orientierung und Anordnung der Erfindung und ihrer Elemente im dreidimensionalen Raum benennen, primär dazu dienen, Bezugspunkte, Bezugsrichtungen und Bezugsorientierungen zur leichteren und verständlicheren Beschreibung und Definition der Erfindung anzugeben, und die Erfindung insgesamt nicht auf eine bestimmte Orientierung im dreidimensionalen Raum beschränken. Dabei ist jedoch die horizontale Ausrichtung des Teleskopauszugs an einem Korpus die bestimmungsgemäße Ausrichtung.

Der Begriff "senkrecht" wird hierin nicht im Sinne von "vertikal" verwendet, sondern zur Beschreibung einer Orientierung in einem rechten Winkel (90°) gegenüber einer in diesem Zusammenhang genannten Orientierung, Richtung oder Ebene. Die Begriffe "Oberseite", "oben", "von oben", "Unterseite", "unten", "von unten", "Höhe" und "Breite" beschreiben Positionen bzw. Richtungen in Bezug auf die Vertikale.

Wenn hierin und im Zusammenhang mit der vorliegenden Erfindung und ihrer Definition von "Auszugsrichtung" und "Einschubrichtung" die Rede ist, beschreibt dies die zwei entgegengesetzten Verfahrrichtungen eines verfahrbar gelagertes Schienenelements gegenüber dem stationären Schienenelement eines Teleskopauszugs, wenn dieser bei bestimmungsgemäßer Orientierung und Verwendung der Erfindung mittels des erfindungsgemäßen Schnellbefestigungssystems an einem Korpus montiert ist. Der Begriff "Verfahrrichtung" beschreibt eine Richtung parallel zur "Auszugsrichtung" und "Einschubrichtung", unabhängig davon, ob das verfahrbar gelagerte Schienenelement ausgezogen oder eingeschoben wird.

Das erfindungsgemäße Schnellbefestigungssystem umfasst wenigstens einen Haltebügel, der direkt oder, wie es insbesondere bei Backöfen üblich ist, mittels eines Seitengitters an dem Korpus festgelegt oder festlegbar ist. Das erfindungsgemäße Schnellbefestigungssystem umfasst weiterhin ein hinteres Schnellbefestigungselement und ein vorderes Schnellbefestigungselement für die Montage des Teleskopauszugs an dem Haltebügel, wobei das hintere und das vordere Schnellbefestigungselement in Auszugsrichtung des Teleskopauszugs in einem Abstand zueinander an dem stationären Schienenelement des an dem Korpus zu montierenden Teleskopauszugs festgelegt oder festlegbar sind. Dabei ist zu Zwecken der Definition der vorderen und hinteren Schnellbefestigungselemente das vordere Schnellbefestigungselement weiter in Auszugsrichtung des Teleskopauszugs angeordnet als das hintere Schnellbefestigungselement. Bei einem Möbel ist somit das hintere Schnellbefestigungselement näher zur Möbelrückwand angeordnet, während das vordere Schnellbefestigungselement näher zur Möbelvorderseite angeordnet ist, aus welcher ein gelagerter Auszug herausgefahren werden soll.

Im Zusammenhang mit der Beschreibung des erfindungsgemäßen Schnellbefestigungssystems, insbesondere des Haltebügels, beschreiben die Begriffe "Schienenseite" bzw. "schienenseitig" eine Anordnung, Position oder Ausrichtung, welche in Bezug auf ein Element, z. B. den Haltebügel, auf der Seite des Elements liegt oder in die Richtung weist, wo bei bestimmungsgemäßer Orientierung und Verwendung der Erfindung das stationäre Schienenelement des Teleskopauszugs verortet ist. Entsprechend beschreiben die Begriffe "Korpusseite" bzw. "korpusseitig" eine Anordnung, Position oder Ausrichtung, welche in Bezug auf ein Element, z. B. den Haltebügel, auf der Seite des Elements liegt oder in die die Richtung weist, wo bei bestimmungsgemäßer Orientierung und Verwendung der Erfindung die Korpusfläche verortet ist, an welcher der Teleskopauszug mittels der Erfindung montiert wird.

Erfindungsgemäß sind das hintere und das vordere Schnellbefestigungselement für einen formschlüssigen oder form- und kraftschlüssigen Eingriff mit dem Haltebügel zum lösbaren Montieren des Teleskopauszugs an dem Haltebügel ausgebildet.

Der Haltebügel des erfindungsgemäßen Schnellbefestigungssystems weist einen sich gerade erstreckenden Horizontalabschnitt und an gegenüberliegenden Enden des Horizontalabschnitts jeweils gegenüber dem Horizontalabschnitt abgewinkelte Endabschnitte auf. Zweckmäßigerweise sind die Endabschnitte in Richtung des Korpus oder des am Korpus festlegbaren Seitengitters abgewinkelt, vorzugsweise in einem Winkel von etwa 90° gegenüber dem Horizontalabschnitt. Der Horizontalabschnitt erstreckt sich zweckmäßigerweise parallel zur Längserstreckung des stationären Schienenelements des Teleskopauszugs und ist vorzugsweise kürzer als das stationäre Schienenelement des Teleskopauszugs. Die angewinkelten Endabschnitte sind vorzugsweise gleich lang. Mit ihren freien Enden, welche nicht mit dem Horizontalabschnitt abgewinkelt verbunden sind, sind die Endabschnitte jeweils am Korpus oder an einem Seitengitter, z. B. an vertikalen Gitterstäben eines Seitengitters festgelegt oder festlegbar.

Der Horizontalabschnitt des Haltebügels weist erfindungsgemäß einen Querschnitt senkrecht zu seiner Längserstreckung auf, der bei einer im Wesentlichen horizontalen Ausrichtung des Horizontalabschnitts in seiner größten Ausdehnung eine Höhe (H) besitzt, welche wenigstens zweimal so groß ist wie seine Breite (B) senkrecht zur Höhe (H). In einer bevorzugten Ausführungsform der Erfindung ist der Querschnitt des Haltebügels ein zusammenhängender Querschnitt, d. h. dass es keine nicht zusammenhängenden Querschnittsflächen gibt. Vorzugsweise weist der Haltebügel im Querschnitt schienenseitig und/oder korpusseitig gerade Seitenflächen auf, welche jedoch abschnittsweise Ausnehmungen oder Erhebungen für einen nachfolgend noch beschriebenen Eingriff mit den Schnellbefestigungselementen aufweisen können.

Der erfindungsgemäße Querschnitt des Horizontalabschnitts des Haltebügels hat gegenüber dem üblicherweise kreisförmigen Querschnitt der horizontalen Gitterstäbe, wie sie bekanntermaßen bei Seitengittern für Backöfen zum Auflegen oder Einschieben von Gargutträgern oder auch zum Befestigen von Teleskopauszügen eingesetzt werden, wesentliche Vorteile. Während die Befestigung an Gitterstäben mit kreisförmigem Querschnitt zur Sicherung des Teleskopauszugs gegen ein Verkippen um die Längsachse des Gitterstabs wenigstens zwei weitere Abstützungen erforderlich sind, benötigt das erfindungsgemäße Schnellbefestigungssystem bei formschlüssigem Eingriff der Schnellbefestigungselemente mit dem erfindungsgemä-ßen Querschnitt des Horizontalabschnitts des Haltebügels keine zusätzlichen Abstützungen gegen das Verkippen. Darüber hinaus stabilisiert der erfindungsgemäße Querschnitt den Horizontalabschnitt des Haltebügels gegen ein Verbiegen bei Belastung von oben.

Erfindungsgemäß weisen das hintere und das vordere Schnellbefestigungselement jeweils folgende Merkmale auf, definiert unter Bezugnahme auf den Haltebügel, wenn die Schnellbefestigungselemente für ein lösbares Montieren des Teleskopauszugs mit dem Haltebügel in Eingriff sind:

Das hintere und das vordere Schnellbefestigungselement weisen jeweils eine Befestigungsplatte für eine Festlegung des Schnellbefestigungselements an einer Fläche, vorzugsweise einer korpusseitigen, d. h. dem verfahrbar gelagerten Schienenelement abgewandten Fläche des stationären Schienenelements des Teleskopauszugs auf. Zweckmäßigerweise liegt die Befestigungsplatte des Schnellbefestigungselements an dieser Fläche des stationären Schienenelements des Teleskopauszugs an und ist an dieser befestigt, vorzugsweise durch Schwei-ßen, Punktschweißen, Nieten oder Verschrauben. Für eine Montage des Teleskopauszugs auf der Schienenseite des Haltebügels, d. h. auf der dem Korpus abgewandten Seite, ist die Befestigungsplatte zweckmäßigerweise vertikal ausrichtet und mit einer entsprechend vertikalen Fläche des stationären Schienenelements des Teleskopauszugs verbunden bzw. verbindbar.

Das hintere und das vordere Schnellbefestigungselement weisen erfindungsgemäß weiterhin jeweils einen Auflageabschnitt auf, welcher sich von der Befestigungsplatte über den Horizontalgitterstab erstreckt und sich von oben auf diesem abstützt. Vorzugsweise weist der Auflageabschnitt über dem Horizontalabschnitt des Haltebügels einen Abschnitt auf der sich senkrecht zur Befestigungsplatte erstreckt. Weiter vorzugsweise ist die Kontur des Auflageabschnitts im Querschnitt zumindest abschnittsweise der Kontur der Oberseite des Horizontalabschnitt des Haltebügels angepasst.

Des Weiteren weisen das hintere und das vordere Schnellbefestigungselement erfindungsgemäß jeweils einen ersten Sicherungsabschnitt auf, welcher sich von der Befestigungsplatte schienenseitig des Horizontalabschnitts des Haltebügels vertikal nach unten erstreckt und schienenseitig am Horizontalabschnitt des Haltebügels anliegt. Vorzugsweise ist die Kontur des ersten Sicherungsabschnitt im Querschnitt zumindest abschnittsweise der Kontur der Schienenseite des Horizontalabschnitt des Haltebügels angepasst.

Weiterhin weisen das hintere und das vordere Schnellbefestigungselement erfindungsgemäß jeweils einen zweiten Sicherungsabschnitt auf, welcher sich an den Auflageabschnitt anschließt und sich korpusseitig des Horizontalabschnitts des Haltebügels vertikal nach unten erstreckt und korpusseitig am Horizontalabschnitt des Haltebügels anliegt. Vorzugsweise ist die Kontur des zweiten Sicherungsabschnitt im Querschnitt zumindest abschnittsweise der Kontur der Korpusseite des Horizontalabschnitt des Haltebügels angepasst.

In Blickrichtung der Längserstreckung des Horizontalabschnitts des Haltebügels umgreifen der Auflageabschnitt, der erste Sicherungsabschnitt und der zweite Sicherungsabschnitt den Horizontalabschnitt somit im Wesentlichen U-förmig von oben und wenigstens abschnittsweiseformschlüssig und sichern so die Schnellbefestigungselemente gegen ein Verkippen um die Längsachse des Horizontalabschnitts des Haltebügels.

In einer bevorzugten Ausführungsform der Erfindung sind das hintere Schnellbefestigungselement, das vordere Schnellbefestigungselement oder beide Schnellbefestigungselemente einstückig aus einem Blech, vorzugsweise einem Stahlblech, ausgebildet. Dabei werden zweckmäßigerweise die erforderlichen Konturen aus dem flachen Blech gestanzt oder geschnitten, sodass die einzelnen Abschnitte des Schnellbefestigungselements miteinander verbunden bleiben, und das Blech anschließend gebogen und gegebenenfalls geprägt, um die einzelnen Abschnitte des Schnellbefestigungselements in die hierin beschriebene erfindungsgemäße Form, Position und Orientierung zu bringen. Die Schnellbefestigungselemente lassen sich so preiswert und effizient aus einem Stück herstellen, ohne dass zusätzliche Verbindungsprozesse, wie Schweißen oder Verschrauben erforderlich sind.

Bei einem derart mit Vorteil einstückig aus einem Blech hergestellten Schnellbefestigungselement sind, bezogen auf den am Haltebügel montierten Zustand, in Richtung der Längserstreckung des Horizontalabschnitts des Haltebügels der Auflageabschnitt und der sich an diesen anschließende zweite Sicherungsabschnitt gegenüber dem ersten Sicherungsabschnitt vorzugsweise ohne Überschneidung versetzt angeordnet.

Weiterhin weist erfindungsgemäß das hintere Schnellbefestigungselement einen Aushebesicherungsabschnitt auf, welcher sich in Richtung der Korpusseite abgewinkelt an den ersten Sicherungsabschnitt anschließt und sich horizontal, d. h. in Richtung der Längserstreckung des Horizontalabschnitts des Haltebügels, weiter in Einschubrichtung des Teleskopauszugs erstreckt als der erste Sicherungsabschnitt des hinteren Schnellbefestigungselements.

Der Aushebesicherungsabschnitt ist erfindungsgemäß vertikal in einer Höhe des Schnellbefestigungselements angeordnet, dass er sich unter dem in Einschubrichtung liegenden abgewinkelten Endabschnitt des Haltebügels erstreckt, wenn das hintere Schnellbefestigungselement in einer Position auf dem Haltebügel angeordnet ist, bei welcher der erste Sicherungsabschnitt an dem in Einschubrichtung liegenden abgewinkelten Endabschnitt anliegt oder anstößt.

Der Aushebesicherungsabschnitt verhindert im montierten Zustand, dass das hintere Schnellbefestigungselement außer Eingriff mit dem Haltebügel gebracht und das hintere Ende des Teleskopauszugs an- bzw. ausgehoben wird, wenn beispielsweise das verfahrbare Schienenelement des Teleskopauszugs ausgefahren ist und belastet wird, beispielsweise durch Eigengewicht, das Gewicht eines Auszugs und/oder beim Einwirken einer sonstigen Kraft von oben auf das Schienenelement. Im Falle einer solchen Belastung kommt der Aushebesicherungsabschnitt mit der Unterseite des hinteren, d. h. des in Einschubrichtung liegenden abgewinkelten Endabschnitts des Haltebügels in Anlage und verhindert ein weiteres Anheben des hinteren Schnellbefestigungselements vertikal nach oben.

In einer Ausführungsform der Erfindung sind das hintere und das vordere Schnellbefestigungselement gleich ausgebildet, wodurch der Herstellungsaufwand reduziert werden kann. In diesem Fall weist das vordere Schnellbefestigungselement ebenfalls den für das hintere Schnellbefestigungselement vorgesehenen Aushebeabschnitt auf, jedoch ohne die Funktion wie beim hinteren Schnellbefestigungselement. Es versteht sich, dass für eine Montage eines Paares von Teleskopauszügen auf gegenüberliegenden Seiten eines Korpus, zum Beispiel an gegenüberliegenden Seitenwänden einer Backofenmuffel, die gegenüberliegenden Schnellbefestigungssysteme, einschließlich der Schnellbefestigungselemente, zweckmäßigerweise spiegelbildlich ausgebildet sind.

In einer bevorzugten Ausführungsform der Erfindung weist der Horizontalabschnitt des Haltebügels schienenseitig, korpusseitig oder schienen- und korpusseitig eine oder mehrere Ausnehmungen oder Erhebungen auf, und an dem ersten und/oder dem zweiten Sicherungsabschnitt des Schnellbefestigungselements sind zu den Ausnehmungen oder Erhebungen komplementäre Prägungen, Biegungen oder Profilierungen für einen formschlüssigen Eingriff ausgebildet. Beispielsweise weist der Horizontalabschnitt schienen- und/oder korpusseitig einen Querschnitt auf mit einer konkav verlaufenden Ausnehmung und der an der jeweiligen Seitenfläche des Halteabschnitts zu liegen kommende Sicherungsabschnitt des Schnellbefestigungselements weist eine Prägung, Biegung oder andere Profilierung auf, die beim Montieren des Schnellbefestigungselements an dem Haltebügel über breiteren Querschnittsbereich des Horizontalabschnitts unter aufbringen einer Kraft geführt wird und in der Ausnehmung im Sinne einer Verrastung zu liegen kommt. Hierdurch wird eine zusätzlich Stabilisierung und Sicherung des Schnellbefestigungselements an dem Haltebügel gegen ein unbeabsichtigtes Ausheben geschaffen. Eine solche Formgebung des Horizontalabschnitts des Haltebügels und der Schnellbefestigungselemente für einen zusätzlichen formschlüssigen Eingriff bzw. eine Verrastung kann sowohl im vorderen als auch im hinteren Abschnitt des Haltebügels vorgesehen sein, also auch sowohl für das vordere als auch das hintere Schnellbefestigungselement. Besonders vorteilhaft ist eine solche Formgebung für einen zusätzlichen formschlüssigen Eingriff jedoch im vorderen Abschnitt des Haltebügels, da im hinteren Abschnitt der Aushebesicherungsabschnitt am hinteren Schnellbefestigungselement bereits ein Außereingriffbringen des hinteren Schnellbefestigungselements mit dem Haltebügel verhindert und somit eine zusätzliche Sicherung bietet.

In einer weiteren Ausführungsform der Erfindung weist das vordere Schnellbefestigungselement einen Hebesicherungshaken auf, welcher in einer starren Verbindung mit dem korpusseitigen ersten Sicherungsabschnitt ausgebildet und gegenüber der Befestigungsplatte federnd rückstellfähig in Richtung der Korpusseite ausschwenkbar ist, wobei sich der Hebesicherungshaken abschnittsweise unter dem Horizontalabschnitt des Haltebügels in Richtung der Schienenseite erstreckt, wenn das Schnellbefestigungselement an dem Haltebügel montiert ist. Durch den Hebesicherungshaken wird eine weitere Sicherung gegen ein unbeabsichtigtes Ausheben des Teleskopauszugs im vorderen Bereich des Haltebügels geschaffen. Zum Lösen der Aushebesicherung durch den Hebesicherungshaken für eine Demontage des Teleskopauszugs von dem Haltebügel kann dieser von der Bedienperson entgegen der federnden Rückstellkraft in Richtung der Korpusseite gedrückt und so das Schnellbefestigungselementfür ein Anheben freigegeben werden. Alternativ oder ergänzend kann an dem Hebesicherungshaken eine von der Korpusseite in Richtung der Schienenseite abfallende Schräge vorgesehen sein, welche beim Anheben des mit dem Teleskopauszug verbundenen vorderen Schnellbefestigungselements mit erhöhtem Kraftaufwand ein Ausschwenken des Hebesicherungshakens in Richtung der Korpusseite dadurch bewirkt, dass aufgrund der Schräge beim Heranführen des Hebesicherungshakens an die Unterseite des Halteabschnitts eine Kraftkomponente in Richtung der Korpusseite erzeugt wird.

Die Erfindung umfasst auch ein Schnellbefestigungssystem, welches ein Seitengitter umfasst, das für eine Festlegung an einer Wandfläche des Korpus vorgesehen und ausgelegt ist, vorzugsweise an der Muffelinnenwand eines Backofens, wobei das Seitengitter einen ersten Vertikalgitterstab und einen davon beabstandeten und im Wesentlichen parallel dazu angeordneten zweiten Vertikalgitterstab aufweist und wobei das Seitengitter wenigstens einen Haltebügel oder mehrere in vertikaler Richtung übereinander angeordnete Haltebügel der hierin beschriebenen erfindungsgemäßen Art aufweist und jeder der gegenüber dem Horizontalabschnitt abgewinkelten Endabschnitte eines Haltebügels über sein freies Ende, welches nicht mit dem Horizontalabschnitt abgewinkelt verbunden ist, an jeweils einem der Vertikalgitterstäbe in der Weise festgelegt ist, dass sich der Horizontalabschnitt des Haltebügels im Wesentlichen senkrecht zu den Vertikalgitterstäben erstreckt.

In einer weiteren Ausführungsform der Erfindung umfasst das Schnellbefestigungssystem weiterhin wenigstens einen oder mehrere Teleskopauszüge, welche jeweils ein stationäres Schienenelement und wenigstens ein gegenüber dem stationären Schienenelement verfahrbar gelagertes Schienenelement aufweisen, wobei an dem stationären Schienenelement jedes Teleskopauszugs jeweils ein hinteres und ein vorderes Schnellbefestigungselement festgelegt sind.

Die erfindungsgemäßen vorderen und hinteren Schnellbefestigungselemente sind so ausgebildet und an dem Teleskopauszug angeordnet, dass sie für eine Montage mit dem Teleskopauszug von oben über den Haltebügel geführt und in diesen eingehängt werden können. Zweckmäßigerweise wird bei der Montage des Teleskopauszugs an den Haltebügel zunächst das hintere Schnellbefestigungselement von oben über den Horizontalabschnitt des Haltebügels geführt und in diesen eingehängt und mit dem Teleskopauszug entlang des Horizontalabschnitts nach hinten geschoben, bis sich der Aushebesicherungsabschnitt des hinteren Schnellbefestigungselements unter den in Einschubrichtung liegenden abgewinkelten Endabschnitt des Haltebügels erstreckt, vorzugsweise bis der korpusseitig des Horizontalabschnitts liegende zweite Sicherungsabschnitt des Schnellbefestigungselements an dem in Einschubrichtung liegenden abgewinkelten Endabschnitt des Haltebügels anliegt. Dann wird die Vorderseite des Teleskopauszugs abgesenkt und das vordere Schnellbefestigungselement von oben über den Horizontalabschnitt des Haltebügels geführt und in diesen eingehängt.

Vorzugsweise sind das vordere und hintere Schnellbefestigungselement an dem stationären Schienenelement des Teleskopauszugs in einem Abstand festgelegt, dass das vordere Schnellbefestigungselement mit seinem zweiten Sicherungsabschnitt dabei nahe an dem in Auszugsrichtung liegenden abgewinkelten Endabschnitt des Haltebügels zu liegen kommt, wenn der zweite Sicherungsabschnitt des hinteren Schnellbefestigungselements an dem in Einschubrichtung liegenden abgewinkelten Endabschnitt des Haltebügels anliegt. So wird das stationäre Schienenelement des Teleskopauszugs auch in Auszugsrichtung auf dem Haltebügel fixiert bzw. mit wenig Spiel in Verfahrrichtung festgelegt.

### FIGUREN

Weitere Vorteile, Merkmale und Anwendungsmöglichkeiten der vorliegenden Erfindung werden anhand der folgenden Beschreibung einer erfindungsgemäßen Ausführungsform und der dazugehörigen Figuren deutlich. In den Figuren sind gleiche Elemente mit gleichen Bezugszeichen bezeichnet.
- Figur 1: zeigt eine perspektivische Ansicht einer Ausführungsform des erfindungsgemäßen Schnellbefestigungssystems mit einem Seitengitter und einem mittels erfindungsgemäßen Schnellbefestigungselementen an einem erfindungsgemäßen Haltebügel montierten Teleskopauszug mit Blickrichtung von schräg oben aus Richtung der Korpusseite.
- Figur 2: zeigt eine weggebrochene Detailansicht der Ausführungsform gemäß Figur 1 im Bereich des vorderen Schnellbefestigungselements mit Blickrichtung von schräg oben aus Richtung der Korpusseite.
- Figur 3: zeigt eine weggebrochene Detailansicht der Ausführungsform gemäß Figur 1 im Bereich des hinteren Schnellbefestigungselements mit Blickrichtung von schräg unten aus Richtung der Korpusseite.
- Figur 4: zeigt eine Ansicht auf einen Querschnitt durch das vordere Schnellbefestigungselement und den in diesem Abschnitt mit einer Ausnehmung versehenen Horizontalabschnitt des Haltebügels der Ausführungsform gemäß Figur 1.
- Figur 5: zeigt eine Ansicht auf einen Querschnitt durch das hintere Schnellbefestigungselement und den in diesem Abschnitt nicht mit einer Ausnehmung versehenen Horizontalabschnitt des Haltebügels der Ausführungsform gemäß Figur 1.
- Figur 6: zeigt eine Ansicht auf einen Querschnitt durch eine alternative Ausführungsform eines vorderen Schnellbefestigungselements mit einem Hebesicherungshaken und den in diesem Abschnitt nicht mit einer Ausnehmung versehenen Horizontalabschnitt des Haltebügels.
- Figur 7: zeigt Ansichten des vorderen Schnellbefestigungselements (baugleich mit dem hinteren Schnellbefestigungselement) der Ausführungsform gemäß Figuren 1 bis 5 aus verschiedenen Blickrichtungen: (a) von vorne; (b) von links, (c) von schräg oben rechts; (d) von schräg oben links; (e) von unten.

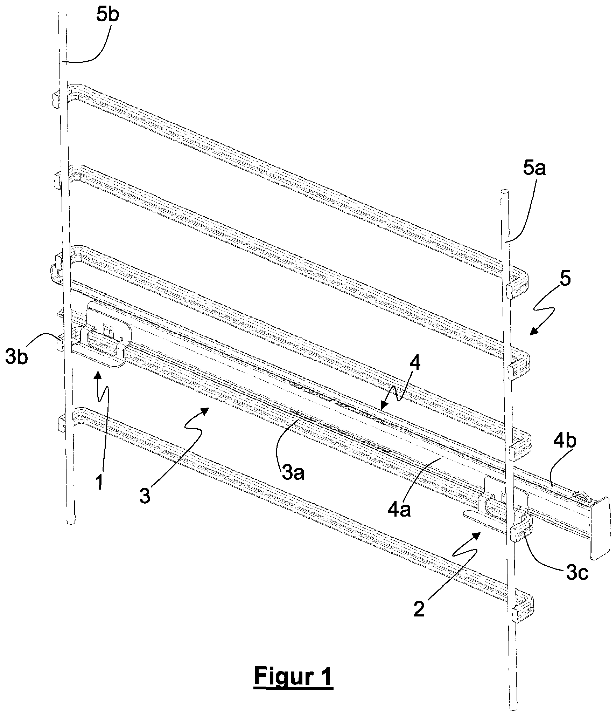

Figur 1 zeigt eine perspektivische Ansicht einer Ausführungsform des erfindungsgemäßen Schnellbefestigungssystems mit einem Seitengitter 5 mit einem ersten (vorderen) Vertikalgitterstab 5a und einem parallel in einem Abstand dazu angeordneten zweiten (hinteren) Vertikalgitterstab 5b sowie mehreren an den Vertikalgitterstäben übereinander festgelegten Haltebügeln 3. Jeder Haltebügel 3 weist einen sich gerade erstreckenden Horizontalabschnitt 3a und an gegenüberliegenden Enden des Horizontalabschnitts 3a jeweils senkrecht dazu abgewinkelte Endabschnitte 3b und 3c auf, welche über ihre freien Enden, die nicht mit dem Horizontalabschnitt 3a abgewinkelt verbunden sind, an jeweils einem der Vertikalgitterstäbe 5a, 5b in der Weise festgelegt sind, dass sich der Horizontalabschnitt 3a des Haltebügels 3 senkrecht zu den Vertikalgitterstäben 5a, 5b und bei bestimmungsgemäßem Einsatz der Vorrichtung horizontal erstreckt.

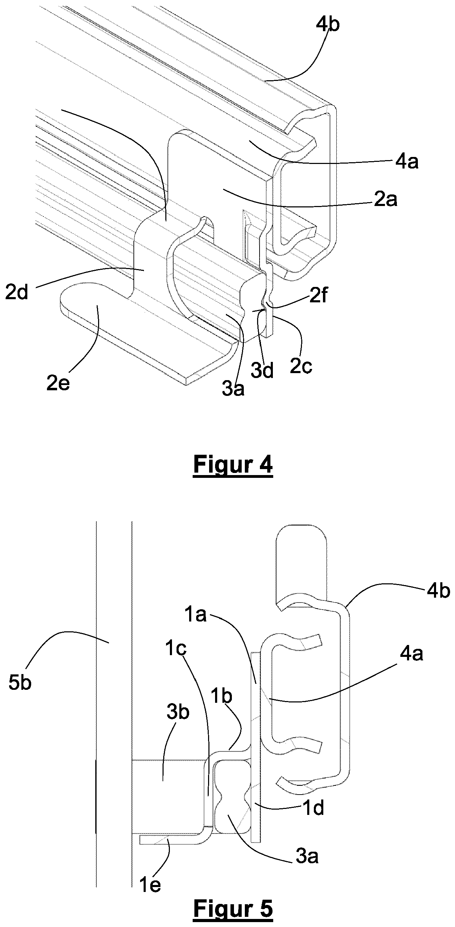

An einem der Haltebügel 3 ist bestimmungsgemäß mittels des erfindungsgemäßen Schnellbefestigungssystems ein Teleskopauszugs 4 mit einem stationären Schienenelement 4a und einem demgegenüber kugelgelagert verfahrbaren stationären Schienenelement 4a montiert. Das stationäre Schienenelement 4a hat ein übliches C-förmiges Profil mit einer im Wesentlichen geraden Rückseite, welche die Kugellaufflächen des Schienenelements verbindet und eine Fläche zur Befestigung eines erfindungsgemäßer Schnellbefestigungselemente 1 und 2 bietet (siehe auch Figuren 4 und 5 - dort ohne Kugellager dargestellt). Das hintere Schnellbefestigungselements 1 ist im hinteren Bereich des Schienenelements 4a bzw. des Haltebügels 3 festgelegt, sodass es im hier gezeigten montierten Zustand mit dem korpusseitigen ersten Sicherungsabschnitt 1c am hinteren abgewinkelter Endabschnitt 3b des Haltebügels 3 anliegt und sich der Aushebesicherungsabschnitt 1e abschnittsweise unter den abgewinkelter Endabschnitt 3b erstreckt. Das vordere Schnellbefestigungselement 2 im vorderen Bereich des Schienenelements 4a bzw. des Haltebügels 3 festgelegt, sodass es im hier gezeigten montierten Zustand mit dem korpusseitigen ersten Sicherungsabschnitt 2c in Auszugsrichtung des Teleskopauszugs 4 fast bis an den vorderen abgewinkelter Endabschnitt 3c des Haltebügels 3 heranreicht.

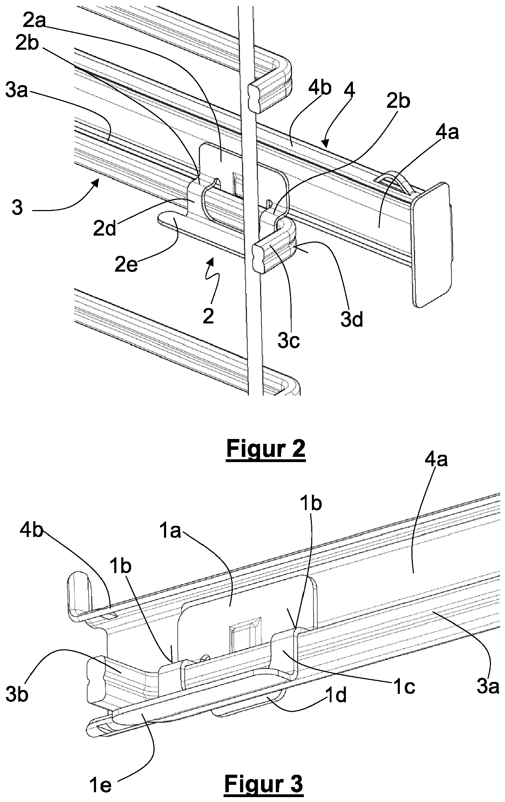

Die Schnellbefestigungselemente 1 und 2 dieser Ausführungsform sind jeweils einstückig aus etwa 1 mm dickem Stahlblech durch Ausstanzen der Strukturen, Prägen und Biegen hergestellt. Wie man auch in den weiteren Detailansichten der Figuren 2 bis 4 und 7 erkennt, sind herstellungsbedingt bei den Schnellbefestigungselementen 1 und 2 in Richtung der Längserstreckung des Horizontalabschnitts 3a des Haltebügels 3 der Auflageabschnitt 1b bzw. 2b und der sich an diesen anschließende zweite Sicherungsabschnitt 1d bzw. 2d gegenüber dem ersten Sicherungsabschnitt 1c bzw. 2c ohne Überschneidung versetzt angeordnet.

Figur 2zeigt eine weggebrochene Detailansicht der Ausführungsform gemäß Figur 1 im Bereich des vorderen Schnellbefestigungselements 2. Das vordere Schnellbefestigungselement 2 ist über die Befestigungsplatte 2a am stationären Schienenelement 4a des Teleskopauszugs 4 festgelegt. Der Haltebügel 3 dieser Ausführungsform besitzt durchgängig einen im Wesentlichen rechteckigen Querschnitt mit abgerundeten Ecken und auf etwa halber Höhe sowohl korpus- als auch schienenseitig jeweils eine sich über den gesamten Haltebügel erstreckende Ausnehmung 3d. Der Auflageabschnitt 2b erstreckt sich von der Befestigungsplatte 2a über den Horizontalabschnitt 3a des Haltebügels 3 und stützt sich von oben auf diesem ab. An den Auflageabschnitt 2b schließt sich abgewinkelt der zweite Sicherungsabschnitt 2d an, erstreckt sich korpusseitig des Horizontalabschnitts 3a des Haltebügels 3 vertikal nach unten und liegt korpusseitig am Horizontalabschnitt 3a des Haltebügels 3 an. Der Auflageabschnitt 2b und der zweite Sicherungsabschnitt 2d erstrecken sich bei dieser bevorzugten Ausführungsform bezogen auf die Längsrichtung des Haltebügels zweigeteilt von der Befestigungsplatte 2a, und bei Blickrichtung von vorne erstreckt sich dazwischen von der Befestigungsplatte 2a aus der erste Sicherungsabschnitt 2c schienenseitig des Horizontalabschnitts 3a des Haltebügels 3 vertikal nach unten und liegt schienenseitig am Horizontalabschnitt 3a des Haltebügels 3 an.

An den ersten Sicherungsabschnitt 2d schließt sich in Richtung der Korpusseite abgewinkelt ein Aushebesicherungsabschnitt 2e an, welcher sich mit einem Abschnitt horizontal weiter in Einschubrichtung des Teleskopauszugs 4 erstreckt als der erste Sicherungsabschnitt 2d. Allerdings ist der Aushebesicherungsabschnitt 2e bei dem vorderen Schnellbefestigungselement 2 ohne Funktion, während er bei dem baugleichen hinteren Schnellbefestigungselement 1 eine Aushebesicherung in hinteren Bereich des Teleskopauszugs bewirkt.

Figur 3 zeigt eine weggebrochene Detailansicht der Ausführungsform gemäß Figur 1 im Bereich des hinteren Schnellbefestigungselements 1, welches gleich ausgebildet ist wie das vordere Schnellbefestigungselement 2. Figur 3 zeigt, wie der Aushebesicherungsabschnitt 1e des hinteren Schnellbefestigungselements 1 im montierten Zustand unter den hinteren abgewinkelter Endabschnitt 3b des Haltebügels 3 zu liegen kommt und eine Aushebesicherung in hinteren Bereich des Teleskopauszugs bewirkt.

Figur 4 zeigt eine Ansicht auf einen Querschnitt durch das vordere Schnellbefestigungselement 2 und im montierten Zustand am Horizontalabschnitt 3a des Haltebügels 3. Der sich schienenseitig des Horizontalabschnitt 3a des Haltebügels 3 vertikal nach unten erstreckende erste Sicherungsabschnitt 2c weist eine zur Ausnehmung 3d komplementäre, zumindest aber passende Prägung oder Biegung 2f für einen formschlüssigen Eingriff des ersten Sicherungsabschnitt 2c mit dem Horizontalabschnitt 3a im montierten Zustand.

Figur 5 zeigt eine Ansicht auf einen Querschnitt durch das hintere Schnellbefestigungselement 1 mit Blickrichtung von vorne nach hinten.

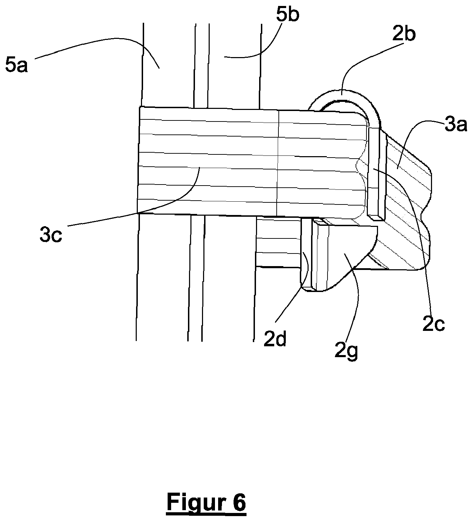

Figur 6 zeigt eine Ansicht auf einen Querschnitt durch eine alternative Ausführungsform eines vorderen Schnellbefestigungselements 2 mit einem Hebesicherungshaken 2g, welcher in einer starren Verbindung mit dem korpusseitigen ersten Sicherungsabschnitt 2c des vorderen Schnellbefestigungselements 2 ausgebildet und gegenüber der Befestigungsplatte 2a (hier nicht dargestellt) federnd rückstellfähig in Richtung der Korpusseite ausschwenkbar ist. Der Hebesicherungshaken 2g erstreckt sich im montierten Zustand abschnittsweise unter dem Horizontalabschnitt 3a des Haltebügels 3 in Richtung der Schienenseite.

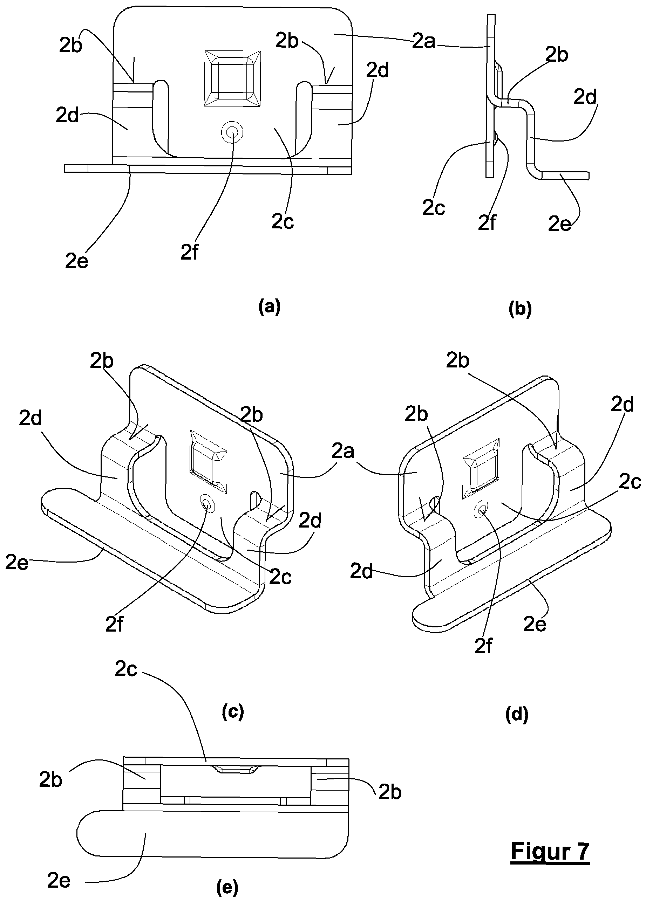

Figur 7 zeigt Ansichten des vorderen Schnellbefestigungselements der Ausführungsform gemäß Figuren 1 bis 5 alleine aus verschiedenen Blickrichtungen. Es ist in diesem Fall baugleich mit dem hinteren Schnellbefestigungselement ausgebildet, wobei beim hinteren Schnellbefestigungselement die Prägung 2f entfallen kann.

Während die Erfindung im Detail in den Zeichnungen und der vorangehenden Beschreibung dargestellt und beschrieben wurde, erfolgt diese Darstellungsbeschreibung lediglich beispielhaft und ist nicht als Beschränkung des Schutzbereichs gedacht, so wie er durch die Ansprüche definiert wird. Die Erfindung ist nicht auf die dargestellten Ausführungsformen beschränkt.

### BEZUGSZEICHENLISTE

- 1: hinteres Schnellbefestigungselement
- 1a: Befestigungsplatte
- 1b: Auflageabschnitt
- 1c: erster (schienenseitiger) Sicherungsabschnitt
- 1d: zweiter (korpusseitiger) Sicherungsabschnitt
- 1e: Aushebesicherungsabschnitt
- 2: vorderes Schnellbefestigungselement
- 2a: Befestigungsplatte
- 2b: Auflageabschnitt
- 2c: erster (schienenseitiger) Sicherungsabschnitt
- 2d: zweiter (korpusseitiger) Sicherungsabschnitt
- 2e: Aushebesicherungsabschnitt
- 2f: Prägung, Biegung oder Profilierung
- 2g: Hebesicherungshaken
- 3: Haltebügel
- 3a: Horizontalabschnitt des Haltebügels
- 3b: (hinterer) abgewinkelter Endabschnitt des Haltebügels
- 3c: (vorderer) abgewinkelter Endabschnitt des Haltebügels
- 3d: Ausnehmung, Einprägung
- 4: Teleskopauszug
- 4a: stationäres Schienenelement
- 4b: verfahrbares Schienenelement
- 5: Seitengitter
- 5a: erster Vertikalgitterstab
- 5b: zweiter Vertikalgitterstab

## Patentansprüche

1. Schnellbefestigungssystem, welches geeignet und ausgelegt ist für ein lösbares Montieren eines Teleskopauszugs (4), welcher ein stationäres Schienenelement (4a) und wenigstens ein gegenüber dem stationären Schienenelement (4a) verfahrbar gelagertes Schienenelement (4b) aufweist, in einer im Wesentlichen horizontalen Ausrichtung des Teleskopauszugs (4) an einem Korpus,
wobei das Schnellbefestigungssystem einen direkt oder mittels eines Seitengitters (5) an dem Korpus festgelegten oder festlegbaren Haltebügel (3) sowie ein hinteres Schnellbefestigungselement (1) und ein vorderes Schnellbefestigungselement (2) umfasst,
wobei das hintere und das vordere Schnellbefestigungselement (1, 2) in Auszugsrichtung des Teleskopauszugs (4) in einem Abstand zueinander und mit dem vorderen Schnellbefestigungselement (2) weiter in Auszugsrichtung als das hintere Schnellbefestigungselement (1) an dem stationären Schienenelement (4a) des an dem Korpus zu montierenden Teleskopauszugs (4) festgelegt oder festlegbar sind und wobei das hintere und das vordere Schnellbefestigungselement (1, 2) für einen formschlüssigen oder form- und kraftschlüssigen Eingriff mit dem Haltebügel (3) zum lösbaren Montieren des Teleskopauszugs (4) an dem Haltebügel (3) ausgebildet sind,
wobei der Haltebügel (3) einen sich gerade erstreckenden Horizontalabschnitt (3a) und an gegenüberliegenden Enden des Horizontalabschnitts (3a) jeweils gegenüber dem Horizontalabschnitt (3a) abgewinkelte Endabschnitte (3b, 3c) aufweist und wobei der Horizontalabschnitt (3a) des Haltebügels (3) einen Querschnitt senkrecht zu seiner Längserstreckung (L) aufweist, der bei einer im Wesentlichen horizontalen Ausrichtung des Horizontalabschnitts (3a) in seiner größten Ausdehnung eine Höhe (H) besitzt, welche wenigstens zweimal so groß ist wie seine Breite (B) senkrecht zur Höhe (H),
wobei das hintere und das vordere Schnellbefestigungselement (1, 2) jeweils folgende Merkmale aufweisen, definiert unter Bezugnahme auf den Haltebügel (3), wenn die Schnellbefestigungselemente für ein lösbares Montieren des Teleskopauszugs (4) mit dem Haltebügel (3) in Eingriff sind:
- eine Befestigungsplatte (1a, 2a) für eine Festlegung des Schnellbefestigungselements (1, 2) an einer Fläche des stationären Schienenelements (4a) des Teleskopauszugs (4),
- einen Auflageabschnitt (1b, 2b), welcher sich von der Befestigungsplatte (1a, 2a) über den Horizontalabschnitt (3a) des Haltebügels (3) erstreckt und sich von oben auf diesem abstützt,
- einen ersten Sicherungsabschnitt (1c, 2c), welcher sich von der Befestigungsplatte (1a, 2a) schienenseitig des Horizontalabschnitts (3a) des Haltebügels (3) vertikal nach unten erstreckt und schienenseitig am Horizontalabschnitt (3a) des Haltebügels (3) anliegt,
- einen zweiten Sicherungsabschnitt (1d, 2d), welcher sich an den Auflageabschnitt (1b, 2b) anschließt und sich korpusseitig des Horizontalabschnitts (3a) des Haltebügels (3) vertikal nach unten erstreckt und korpusseitig am Horizontalabschnitt (3a) des Haltebügels (3) anliegt,
wobei das hintere Schnellbefestigungselement (1) einen Aushebesicherungsabschnitt (1e) aufweist, welcher sich in Richtung der Korpusseite abgewinkelt an den ersten Sicherungsabschnitt (1c) anschließt und sich horizontal weiter in Einschubrichtung des Teleskopauszugs (4) erstreckt als der erste Sicherungsabschnitt (1c) des hinteren Schnellbefestigungselements (1), wobei der Aushebesicherungsabschnitt (1e) vertikal in einer Höhe des Schnellbefestigungselements (1) angeordnet ist, dass er sich unter dem in Einschubrichtung liegenden abgewinkelten Endabschnitt (3b) des Haltebügels (3) erstreckt, wenn das hintere Schnellbefestigungselement (1) in einer Position auf dem Haltebügel (3) angeordnet ist, bei welcher der erste Sicherungsabschnitt (1c) an dem in Einschubrichtung liegenden abgewinkelten Endabschnitt (3b) anliegt.

2. Schnellbefestigungssystem nach Anspruch 1, **dadurch gekennzeichnet, dass** der Horizontalabschnitt (3a) des Haltebügels (3) schienenseitig, korpusseitig oder schienen- und korpusseitig eine oder mehrere Ausnehmungen oder Erhebungen (3d) aufweist und an dem ersten Sicherungsabschnitt (1c, 2c), dem zweiten Sicherungsabschnitt (1d, 2d) oder an beiden Sicherungsabschnitten zu den Ausnehmungen oder Erhebungen (3d) komplementäre Prägungen, Biegungen oder Profilierungen (1f, 2f) für einen formschlüssigen Eingriff ausgebildet sind.

3. Schnellbefestigungssystem nach einem der vorausgehenden Ansprüche, **dadurch gekennzeichnet, dass** der Horizontalabschnitt (3a) des Haltebügels (3) senkrecht zu seiner Längserstreckung (L) einen zusammenhängenden Querschnitt aufweist.

4. Schnellbefestigungssystem nach einem der vorausgehenden Ansprüche, **dadurch gekennzeichnet, dass** das hintere und das vordere Schnellbefestigungselement (1, 2) gleich ausgebildet sind.

5. Schnellbefestigungssystem nach einem der vorausgehenden Ansprüche, **dadurch gekennzeichnet, dass** das hintere Schnellbefestigungselement (1), das vordere Schnellbefestigungselement (2) oder beide Schnellbefestigungselemente (1, 2) einstückig aus einem Blech, vorzugsweise einem Stahlblech, ausgebildet ist.

6. Schnellbefestigungssystem nach einem der vorausgehenden Ansprüche, **dadurch gekennzeichnet, dass** das vordere Schnellbefestigungselement (2) einen Hebesicherungshaken (2g) aufweist, welcher in einer starren Verbindung mit dem korpusseitigen ersten Sicherungsabschnitt (2c) ausgebildet und gegenüber der Befestigungsplatte (2a) federnd rückstellfähig in Richtung der Korpusseite ausschwenkbar ist, wobei sich der Hebesicherungshaken (2g) abschnittsweise unter dem Horizontalabschnitt (3a) des Haltebügels (3) in Richtung der Schienenseite erstreckt.

7. Schnellbefestigungssystem nach einem der vorausgehenden Ansprüche, **dadurch gekennzeichnet, dass** die Befestigungsplatte (1a, 2a) des Schnellbefestigungselements (1, 2) an einer dem verfahrbar gelagerten Schienenelement (4b) abgewandten Fläche des stationären Schienenelements (4a) des Teleskopauszugs (4) anliegt und an dieser befestigt ist, vorzugsweise durch Schweißen, Punktschweißen, Nieten oder Verschrauben.

8. Schnellbefestigungssystem nach einem der vorausgehenden Ansprüche, **dadurch gekennzeichnet, dass** es ein Seitengitter (5) umfasst, welches für eine Festlegung an einer Wandfläche des Korpus vorgesehen und ausgelegt ist, wobei das Seitengitter (5) einen ersten Vertikalgitterstab (5a) und einen davon beabstandeten und im Wesentlichen parallel dazu angeordneten zweiten Vertikalgitterstab (5b) aufweist und wobei das Seitengitter (5) wenigstens einen Haltebügel (3) oder mehrere in vertikaler Richtung übereinander angeordnete Haltebügel (3) aufweist und jeder der gegenüber dem Horizontalabschnitt (3a) abgewinkelten Endabschnitte (3b, 3c) eines Haltebügels (3) über sein freies Ende, welches nicht mit dem Horizontalabschnitt (3a) abgewinkelt verbunden ist, an jeweils einem der Vertikalgitterstäbe (5a, 5b) in der Weise festgelegt ist, dass sich der Horizontalabschnitt (3a) des Haltebügels (3) im Wesentlichen senkrecht zu den Vertikalgitterstäben (5a, 5b) erstreckt.

9. Schnellbefestigungssystem nach Anspruch 8, **dadurch gekennzeichnet, dass** es wenigstens einen oder mehrere Teleskopauszüge (4) umfasst, welche jeweils ein stationäres Schienenelement (4a) und wenigstens ein gegenüber dem stationären Schienenelement (4a) verfahrbar gelagertes Schienenelement (4b) aufweisen, wobei an dem stationären Schienenelement (4a) jedes Teleskopauszugs (4) jeweils ein hinteres und ein vorderes Schnellbefestigungselement (1, 2) festgelegt sind.

## Claims

1. A quick-fastening system which is suitable and designed for releasably mounting a telecopic extension (4), which has a stationary rail element (4a) and at least one rail element (4b) which is movably mounted relative to the stationary rail element (4a), in a substantially horizontal orientation of the telescopic extension (4) on a corpus,
wherein the quick-fastening system comprises a retaining bracket (3), which is fixed or can be fixed to the corpus directly or by means of a side grid (5), as well as a rear quick-fastening element (1) and a front quick-fastening element (2),
wherein the rear and the front quick-fastening elements (1, 2) are fixed or fixable to the stationary rail element (4a) of the telescopic extension (4) to be mounted on the corpus at a distance from one another in the extension direction of the telescopic extension (4) and with the front quick-fastening element (2) further in the extension direction than the rear quick-fastening element (1), and wherein the rear and the front quick-fastening elements (1, 2) are designed for positive or positive and friction-fitting engagement with the retaining bracket (3) for detachable mounting of the telescopic extension (4) on the retaining bracket (3),
wherein the retaining bracket (3) has a horizontal section (3a) extending straight and end sections (3b, 3c) at opposite ends of the horizontal section (3a), which are each angled relative to the horizontal section (3a), and wherein the horizontal section (3a) of the retaining bracket (3) has a cross-section perpendicular to its longitudinal extent (L) which, when the horizontal section (3a) is oriented substantially horizontally, has a height (H) in its greatest extent which is at least twice as great as its width (B) perpendicular to the height (H),
wherein the rear and front quick-fastening elements (1, 2) each have the following features, defined with reference to the retaining bracket (3), when the quick-fastening elements are engaged with the retaining bracket (3) for releasable mounting of the telescopic extension (4)
- a fastening plate (1a, 2a) for fastening the quick-fastening element (1, 2) to a surface of the stationary rail element (4a) of the telescopic extension (4),
- a support section (1b, 2b) which extends from the fastening plate (1a, 2a) over the horizontal section (3a) of the holding bracket (3) and is supported on the latter from above,
- a first securing section (1c, 2c), which extends vertically downwards from the fastening plate (1a, 2a) on the rail side of the horizontal section (3a) of the retaining bracket (3) and rests on the rail side against the horizontal section (3a) of the retaining bracket (3),
- a second securing section (1d, 2d), which adjoins the support section (1b, 2b) and extends vertically downwards on the corpus side of the horizontal section (3a) of the retaining bracket (3) and rests on the corpus side against the horizontal section (3a) of the retaining bracket (3),
wherein the rear quick-release fastening element (1) has a lift-out securing section (1e) which adjoins the first securing section (1c) at an angle in the direction of the corpus side and extends horizontally further in the insertion direction of the telescopic extension (4) than the first securing section (1c) of the rear quick-release fastening element (1), wherein the lift-out securing section (1e) is arranged vertically at a height of the quick-release fastening element (1) such that it extends below the angled end section (3b) of the retaining bracket (3) lying in the insertion direction when the rear quick-release fastening element (1) is arranged in a position on the retaining bracket (3) in which the first securing section (1c) bears against the angled end section (3b) lying in the insertion direction.

2. The quick fastening system according to claim 1, **characterized in that** the horizontal section (3a) of the retaining bracket (3) has one or more cutouts or protrusions (3d) on the rail side, on the corpus side or on the rail and corpus sides, and wherein on the first securing section (1c, 2c), the second securing section (1d, 2d) or on both securing sections, embossings, bends or profiles (1f, 2f) complementary to the cutouts or protrusions (3d) are formed for positive engagement.

3. The quick fastening system according to one of the preceding claims, **characterized in that** the horizontal section (3a) of the retaining bracket (3) has a continuous cross-section perpendicular to its longitudinal extension (L).

4. The quick-fastening system according to one of the preceding claims, **characterized in that** the rear and front quick-fastening elements (1, 2) are of the same design.

5. The quick-fastening system according to one of the preceding claims, **characterized in that** the rear quick-fastening element (1), the front quick-fastening element (2) or both quick-fastening elements (1, 2) are formed in one piece from a sheet metal, preferably a sheet steel.

6. The quick-fastening system according to one of the preceding claims, **characterized in that** the front quick-fastening element (2) has a lift-securing hook (2g), which is formed in a rigid connection with the first securing section (2c) on the corpus side and can be pivoted out in the direction of the corpus side in a resiliently restorable manner with respect to the fastening plate (2a), the lift-securing hook (2g) extending over sections under the horizontal section (3a) of the retaining bracket (3) in the direction of the rail side.

7. The quick-fastening system according to one of the preceding claims, **characterized in that** the fastening plate (1a, 2a) of the quick-fastening element (1, 2) rests against a surface of the stationary rail element (4a) of the telescopic extension (4) facing away from the movably mounted rail element (4b) and is fastened thereto, preferably by welding, spot welding, riveting or screwing.

8. The quick-fastening system according to any of the preceding claims, **characterized in that** it comprises a side grid (5) which is provided and designed to be fixed to a wall surface of the corpus, wherein the side grid (5) has a first vertical grid bar (5a) and a second vertical grid bar (5b) spaced therefrom and arranged substantially parallel thereto, and wherein the side grid (5) has at least one retaining bracket (3) or a plurality of retaining brackets (3) arranged one above the other in the vertical direction and each of the end portions (3b, 3c) of a retaining bracket (3) is fixed via its free end, which is not connected at an angle to the horizontal section (3a), to one of the vertical grid bars (5a, 5b) in each case in such a way that the horizontal section (3a) of the retaining bracket (3) extends essentially perpendicular to the vertical grid bars (5a, 5b).

9. The quick-fastening system according to claim 8, **characterized in that** it comprises at least one or more telescopic extensions (4), which each have a stationary rail element (4a) and at least one rail element (4b) mounted so as to be movable relative to the stationary rail element (4a), wherein a rear and a front quick-fastening element (1, 2) are each fixed to the stationary rail element (4a) of each telescopic extension (4).

## Revendications

1. Système de fixation rapide approprié et conçu pour le montage amovible d'une rallonge télescopique (4) comprenant un élément de rail fixe (4a) et au moins un élément de rail (4b) monté mobile par rapport à l'élément de rail fixe (4a), dans une orientation essentiellement horizontale de la rallonge télescopique (4) sur un corps,
le système de fixation rapide comprenant un arceau de maintien (3) fixé ou pouvant être fixé directement ou au moyen d'une grille latérale (5) sur le corps, ainsi qu'un élément de fixation rapide arrière (1) et un élément de fixation rapide avant (2),
les éléments de fixation rapide arrière et avant (1, 2) étant fixés ou pouvant être fixés sur l'élément de rail fixe (4a) de la rallonge télescopique (4) à monter sur le corps, à distance l'un de l'autre dans la direction d'extension de la rallonge télescopique (4), l'élément de fixation rapide avant (2) étant situé plus loin dans la direction d'extension que l'élément de fixation rapide arrière (1), et les éléments de fixation rapide arrière et avant (1, 2) étant conçus pour une mise en prise par complémentarité de forme ou par complémentarité de forme et de force avec l'arceau de maintien (3) en vue d'un montage amovible de la rallonge télescopique (4) sur l'arceau de maintien (3),
l'arceau de maintien (3) comprenant une section horizontale (3a) s'étendant de manière rectiligne et des sections d'extrémité (3b, 3c) respectivement coudées par rapport à la section horizontale (3a) aux extrémités opposées de la section horizontale (3a) et la section horizontale (3a) de l'arceau de maintien (3) comprenant une section transversale perpendiculaire à son extension longitudinale (L) qui, lorsque la section horizontale (3a) est orientée de manière essentiellement horizontale, comprend dans sa plus grande extension une hauteur (H) qui est au moins deux fois plus grande que sa largeur (B) perpendiculaire à la hauteur (H),
les éléments de fixation rapide arrière et avant (1, 2) comprenant respectivement les caractéristiques ci-dessous, définies par rapport à l'arceau de maintien (3), lorsque les éléments de fixation rapide destinés à un montage amovible de la rallonge télescopique (4) sont en prise avec l'arceau de maintien (3) :
- une plaque de fixation (1a, 2a) destinée à la fixation de l'élément de fixation rapide (1, 2) sur une surface de l'élément de rail fixe (4a) de la rallonge télescopique (4),
- une section d'appui (1b, 2b) qui s'étend sur la section horizontale (3a) de l'arceau de maintien (3) à partir de la plaque de fixation (1a, 2a) et qui s'appuie sur ladite section horizontale par le haut,
- une première section de blocage (1c, 2c) qui s'étend verticalement vers le bas à partir de la plaque de fixation (1a, 2a) du côté rail de la section horizontale (3a) de l'arceau de maintien (3) et qui repose du côté rail sur la section horizontale (3a) de l'arceau de maintien (3),
- une seconde section de blocage (1d, 2d), qui se raccorde à la section d'appui (1b, 2b) et qui s'étend verticalement vers le bas, du côté corps de la section horizontale (3a) de l'arceau de maintien (3), et qui repose du côté corps contre la section horizontale (3a) de l'arceau de maintien (3),
l'élément de fixation rapide arrière (1) comprenant une section de blocage de soulèvement (1e) qui se raccorde à la première section de blocage (1c) de manière coudée dans la direction du côté corps et qui s'étend horizontalement plus loin dans la direction d'insertion de la rallonge télescopique (4) que ne le fait la première section de blocage (1c) de l'élément de fixation rapide arrière (1), la section de blocage de soulèvement (1e) étant agencée à une certaine hauteur verticale de l'élément de fixation rapide (1) lui permettant de s'étendre sous la section d'extrémité (3b), coudée dans la direction d'insertion, de l'arceau de maintien (3) lorsque l'élément de fixation rapide arrière (1) est agencé sur l'arceau de maintien (3) dans une position dans laquelle la première section de blocage (1c) repose sur la section d'extrémité (3b) coudée dans la direction d'insertion.

2. Système de fixation rapide selon la revendication 1, **caractérisé en ce que** la section horizontale (3a) de l'arceau de maintien (3) comprend, côté rail, côté corps ou côté rail et corps, un(e) ou plusieurs évidement(s) ou saillie(s) (3d) et **en ce que** des empreintes, des cintrages ou des profilages (1f, 2f) complémentaires aux évidements ou saillies (3d) sont réalisés, en vue d'une mise en prise par complémentarité de forme, à la première section de blocage (1c, 2c), à la seconde section de blocage (1d, 2d) ou aux deux sections de blocage.

3. Système de fixation rapide selon l'une quelconque des revendications précédentes, **caractérisé en ce que** la section horizontale (3a) de l'arceau de maintien (3) comprend une section transversale continue perpendiculairement à son extension longitudinale (L).

4. Système de fixation rapide selon l'une quelconque des revendications précédentes, **caractérisé en ce que** les éléments de fixation rapide arrière et avant (1, 2) sont réalisés de manière identique.

5. Système de fixation rapide selon l'une quelconque des revendications précédentes, **caractérisé en ce que** l'élément de fixation rapide arrière (1), l'élément de fixation rapide avant (2) ou les deux éléments de fixation rapide (1, 2) sont réalisés d'un seul tenant à partir d'une tôle, de préférence d'une tôle d'acier.

6. Système de fixation rapide selon l'une quelconque des revendications précédentes, **caractérisé en ce que** l'élément de fixation rapide avant (2) comprend un crochet de blocage de levage (2g) qui est réalisé en liaison rigide avec la première section de blocage (2c) côté corps et qui peut être pivoté par rapport à la plaque de fixation (2a) en étant capable d'une élasticité de rappel en direction du côté corps, le crochet de blocage de levage (2g) s'étendant par sections sous la section horizontale (3a) de l'arceau de maintien (3) en direction du côté rail.

7. Système de fixation rapide selon l'une quelconque des revendications précédentes, **caractérisé en ce que** la plaque de fixation (1a, 2a) de l'élément de fixation rapide (1, 2) repose sur une surface, opposée à l'élément de rail (4b) monté mobile, de l'élément de rail fixe (4a) de la rallonge télescopique (4) et est fixée à ladite surface, de préférence par soudage, soudage par points, rivetage ou vissage.

8. Système de fixation rapide selon l'une quelconque des revendications précédentes, **caractérisé en ce qu'**il comprend une grille latérale (5) prévue et conçue pour une fixation sur une surface de paroi du corps, la grille latérale (5) comprenant une première barre de grille verticale (5a) et une seconde barre de grille verticale (5b) espacée par rapport à ladite première barre de grille verticale et agencée de manière essentiellement parallèle à ladite première barre de grille verticale, et la grille latérale (5) comprenant au moins un arceau de maintien (3) ou plusieurs arceaux de maintien (3) agencés les uns au-dessus des autres dans la direction verticale, et chacune des sections d'extrémité (3b, 3c), coudées par rapport à la section horizontale (3a), d'un arceau de maintien (3) est fixée à respectivement une des barres de grille verticale (5a, 5b) par son extrémité libre non reliée de manière coudée à la section horizontale (3a), de manière à ce que la section horizontale (3a) de l'arceau de maintien (3) s'étende de manière essentiellement perpendiculaire aux barres de grille verticale (5a, 5b).

9. Système de fixation rapide selon la revendication 8, **caractérisé en ce qu'**il comprend au moins une ou plusieurs rallonge(s) télescopique(s) (4) qui comprend(nent) respectivement un élément de rail fixe (4a) et au moins un élément de rail (4b) monté mobile par rapport à l'élément de rail fixe (4a), respectivement un élément de fixation rapide arrière et un élément de fixation rapide avant (1, 2) étant fixés sur l'élément de rail fixe (4a) de chaque rallonge télescopique (4).
